(19) Europäisches Patentamt
European Patent Office
Office européen des brevets

(11) Numéro de publication: **0 286 482 A1**

(12) # DEMANDE DE BREVET EUROPEEN

(21) Numéro de dépôt: **88400640.4**

(22) Date de dépôt: **17.03.88**

(51) Int. Cl.[4]: **H 01 L 39/12**
H 01 L 39/24

(30) Priorité: **23.03.87 FR 8703975**

(43) Date de publication de la demande:
**12.10.88 Bulletin 88/41**

(84) Etats contractants désignés:
**AT BE CH DE ES FR GB GR IT LI LU NL SE**

(71) Demandeur: **COMPAGNIE GENERALE D'ELECTRICITE**
**Société anonyme dite:**
**54, rue La Boétie**
**F-75382 Paris Cédex 08 (FR)**

(72) Inventeur: **Raveau, Bernard c/o Laboratoire CRISMAT-ISMRA**
**Boulevard du Maréchal Juin**
**F-14032 Caen Cédex (FR)**

**Deslandes, Francis c/o Laboratoire CRISMAT-ISMRA**
**Boulevard du Maréchal Juin**
**F-14032 Caen Cédex (FR)**

**Provost, Jackie c/o Laboratoire CRISMAT-ISMRA**
**Boulevard du Maréchal Juin**
**F-14032 Caen Cédex (FR)**

**Michel, Claude c/o Laboratoire CRISMAT-ISMRA**
**Boulevard du Maréchal Juin**
**F-14032 Caen Cédex (FR)**

**Tournier, Robert**
**c/o C.R.T.B.T.-CNRS B.P. 166 X**
**F-38042 Grenoble Cédex (FR)**

**Lejay, Pascal**
**c/o C.R.T.B.T.-CNRS B.P. 166 X**
**F-38042 Grenoble Cédex (FR)**

(74) Mandataire: **Weinmiller, Jürgen et al**
**Lennéstrasse 9 Postfach 24**
**D-8133 Feldafing (DE)**

(54) **Oxydes de cuivre à valence mixte supraconducteurs et leur procédé de fabrication.**

(57) L'invention concerne, à titre de matériaux supraconducteurs, les oxydes de cuivre à valence mixte du type pérovskite déficitaire en oxygène de formule :

$La_{1+\varepsilon} Ba_{2-\varepsilon} Cu_3O_{8-y}$

avec

$-0{,}2 \leqq \varepsilon \leqq +0{,}2$

$0 < ;y < ;1{,}5$

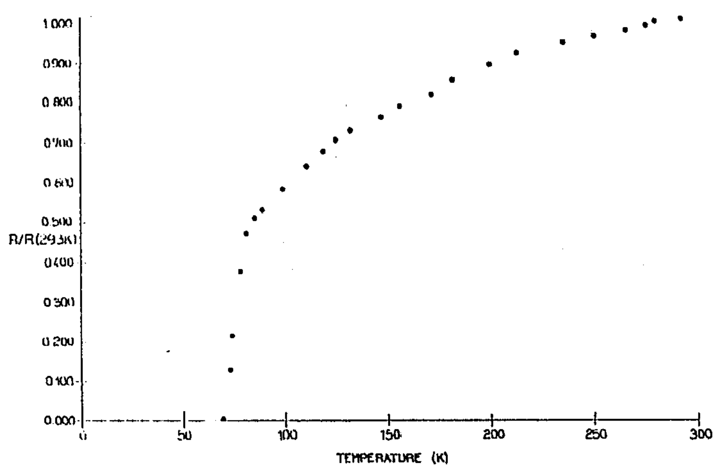


FIG-2

EP 0 286 482 A1

## Description

**Oxydes de cuivre à valence mixte supraconducteurs et leur procédé de fabrication**

La présente invention concerne les matériaux supraconducteurs.

On sait que les oxydes ternaires de cuivre à valence mixte $La_{2-x}A_xCuO_{4-y}$ (A = Ba, Sr) ont ouvert une nouvelle voie de recherche dans le domaine des matériaux supraconducteurs, du fait qu'ils ont montré des températures critiques de 30 à 46 K.

Les travaux menés par les inventeurs dans le système La-Cu-0 leur ont montré que la présence d'ions alcalinoterreux n'était pas indispensable à l'existence de propriétés supraconductrices. L'idée mère de leur invention, en revanche, est que la valence mixte Cu(II)-Cu(III), ainsi que l'effet Jahn-Teller du cuivre divalent jouent un rôle important dans le phénomène de la supraconductivité.

Dans cet esprit, l'invention propose, à titre de matériaux supraconducteurs, une nouvelle classe d'oxydes de cuivre à valence mixte qui comportent une formule du type :

$$La_{1+\varepsilon}Ba_{2-\varepsilon}Cu_3O_{8-y} \quad \text{avec}$$
$$-0{,}2 \leq \varepsilon \leq +0{,}2 \qquad \text{(formules 1)}$$
$$0 < y < 1{,}5.$$

De tels matériaux, dont on décrira plus complètement la structure en se référant au groupe des pérovskites déficitaires en oxygène, présentent des propriétés supraconductrices remarquables.

A titre d'exemple numérique, un oxyde de cuivre à valence mixte obtenu pour $\varepsilon = 0$ dans la formule ci-dessus, valeur correspondant au point central de la gamme, possède les propriétés suivantes :
- température critique : 75 K ;
- conducteur métallique à température ordinaire, avec une résistivité de $2{,}4.10^{-3}\Omega$cm à 293 K ;
- transition franche brutale très étroite à 75 K ;
- résistance nulle en dessous de 75 K ;
- possibilité de courants critiques très élevés ;
- supraconductivité conservée jusqu'à une densité de courant de 10 $A/cm^2$.

L'invention propose également un procédé de préparation de tels matériaux par synthèse directe à partir des oxydes ultrapurs $La_2O_3$, CuO et du carbonate de baryum. Selon l'invention, on mélange intimement ces produits dans des proportions correspondant à la stoechiométrie de la formule recherchée, on chauffe, de préférence à l'air et dans un creuset, le mélange obtenu de préférence pendant une durée de 6 à 12 heures, on broie et on compacte le mélange sous forme de pastilles que l'on fritte sous courant d'oxygène pendant plusieurs heures à une température d'environ 1050°C, et on refroidit lentement ces pastilles, toujours sous courant d'oxygène.

Après avoir défini sommairement l'invention, on va maintenant la décrire plus complètement en se référant à la classe plus générale des pérovskites déficitaires en oxygène, la préparation d'une série typique (correspondant à $\varepsilon = 0$ dans la formule ci-dessus) étant exactement donnée.

On se réfèrera aux figures annexées sur lesquelles :
- Les figures 1a et 1b représentent les deux structures limites entre lesquelles s'inscrit la structure de l'invention ;
- la figure 2 est un diagramme montrant, pour le produit typique de la série typique, la courbe de variation de sa résistance relative (rapport de sa résistance R à sa résistance R(293K) à 293K) en fonction de la température exprimée en degrés K.

Pour l'intelligence de la présente description, et à titre de références didactiques et terminologiques auxquelles le lecteur pourra se reporter, on indique ici les trois publications suivantes :

A/ article de B. RAVEAU "De nombreuses structures d'oxydes peuvent être construites à partir du type de base $ReO_3$" - Proc. Indian natn. Sci Acad., 52, A, No. 1, 1986, pp. 67-101 ;

B/ article de L. ER-RAKHO, C. MICHEL, J. PROVOST et B. RAVEAU "Séries de pérovskites à défaut d'oxygène contenant CuII et CuIII" - Journal of Solid State Chemistry 37, 151-156 (1981) ;

C/ article de C. MICHEL et B. RAVEAU "Intercalation d'oxygène dans les oxydes de cuivre à valence mixte apparentés aux pérovskites" -Revue de Chimie Minérale, t 29, 1984, page 407.

Pris en référence à la classe des pérovskites, les oxydes selon l'invention se présentent comme une nouvelle famille de pérovskites déficitaires en oxygène définies à partir de la formule de base $LaBa_2Cu_3O_{8-y}$.

L'obtention des phases selon l'invention du type $La_{1-x}Ba_xCuO_{3-y}$, (formule 2 équivalente aux formules 1 avec $\varepsilon = 2\text{-}3x$ et $y = 3y'\text{-}1$) se fait de la manière suivante : on mélange intimement les oxydes ultrapurs $La_2O_3$ et CuO ainsi que le carbonate de baryum dans les proportions correspondant à la stoechiométrie de la formule recherchée puis on les chauffe à l'air en creuset de platine pendant 6 à 12 heures à une température comprise entre 900 et 950°C. Le mélange obtenu est ensuite broyé, compacté sous forme de disques de 4 mm d'épaisseur et de 10 mm de diamètre, fritté sous courant d'oxygène pendant deux heures à 1050°C et finalement refroidi dans les mêmes conditions avec une vitesse de descente en température de 30°C par heure.

Dans ces conditions expérimentales données à titre d'exemple de série typique, une pérovskite déficitaire en oxygène a été isolée pour la composition $x = 0{,}66$, soit $\varepsilon = 0$, correspondant à la formulation de base $LaBa_2Cu_3O_{8-y}$. L'étude de cette phase par diffraction X et diffraction électronique montre qu'elle possède la symétrie quadratique avec pour paramètres $a = 3{,}93 Å \sim a_p$ et

$c = 11{,}79Å \sim 3a_p$. Les groupes d'espace possibles pour cette phase (absence de conditions d'extinction) sont compatibles avec un ordre par plans des ions baryum et lanthane. Les deux formules-structures limites $LaBa_2Cu_3O_7$ et $LaBa_2Cu_3O_8$ sont toutes deux compatibles avec un ordre des lacunes oxygène par plans parallèles à (001) entraînant dans le premier cas un plan double de pyramides $CuO_5$ alternant avec un plan de groupes carrés $CuO_4$, et dans le second modèle limite des plans doubles mixtes formés de pyramides $CuO_5$ et d'octaèdres $CuO_6$.

Les figures 1a et 1b représentent respectivement les deux structures limites, avec le symbolisme suivant : gros point noir = baryum ; gros point blanc = La ; petit point noir = cuivre ; petit point blanc = oxygène.

Pour une telle composition et dans un exemple typique ou le dosage chimique du produit préparé correspond à une valeur y de 0,7 ± 0,1, (la valeur de y obtenue dans chaque essai individuel dépendant de la modulation des conditions opératoires), on observe un caractère métallique $\rho \simeq 2{,}4.10^{-3}\Omega$cm à 293 K avec une transition supraconductrice très nette à 75 K comme représenté sur la figure 2 qui montre l'évolution de la résistance relative d'un échantillon. La pérovskite est la phase responsable de la supraconductivité dans le système La-Ba-Cu-0. Il est intéressant de noter que la valence mixte du cuivre est également très nette dans cette phase ; en revanche, le caractère bidimensionnel de cet oxyde qui peut également être décrit comme constitué de couches doubles de polyèdres $CuO_5$ et $CuO_6$ assemblées par l'intermédiaire d'ions baryum est moins marqué que dans les oxydes $La_{2-x}A_xCuO_{4-y}$.

Des essais confortés par des considérations théoriques sur le caractère critique de la répartition des lacunes d'oxygène conduisent les inventeurs à indiquer tous les produits englobés par les formules (1) comme présentant de remarquables propriétés de supraconducteurs.

Il apparaît de plus que l'élévation de la pression d'oxygène durant la synthèse devrait permettre une intercalation d'oxygène plus importante et, en conséquence, une amélioration des propriétés supraconductrices, notamment une élévation de la température de transition. Ce moyen (élévation de la pression d'oxygène) fait partie de l'invention.

Il apparaît enfin que les nouveaux produits selon l'invention présentent une aptitude convenable à être mis en forme (de fils, de feuilles de couches minces ou d'autres composants élémentaires d'ensembles électriques ou électroniques) qui les rendent particulièrement aptes à servir de matériaux supraconducteurs.

L'industrie comprendra tout l'intérêt de matériaux supraconducteurs ayant une transition supraconductrice à une température si élevée qu'elle en devient facilement accessible, dans des ensembles électriques ou électroniques comportant des moyens de refroidissement connus tels que l'azote liquide.

**Revendications**

**1.** A titre de matériaux supraconducteurs, les oxydes de cuivre à valence mixte du type pérovskite déficitaire en oxygène de formule

$La_{1+\varepsilon}Ba_{2-\varepsilon}Cu_3O_{8-y}$

avec

$-0{,}2 \leqq \varepsilon \leqq +0{,}2$

0< ;y< ;1,5.

**2.** Produits selon la revendication 1, caractérisé par une structure intermédiaire entre la structure de la figure 1a et celle de la figure 1b.

**3.** Produits selon l'une des revendications 1 à 2, caractérisés par une valeur de ε voisine de zéro et une température de transition voisine de 75 K.

**4.** Un procédé de préparation des produits selon l'une des revendications 1 à 3, dans lequel on mélange intimement $La_2O_3$, CuO et le carbonate de baryum, dans des proportions correspondant à la stoechiométrie de la formule recherchée, on chauffe, par exemple à l'air et dans un creuset, le mélange obtenu, de préférence pendant une durée de 6 à 12 heures et à une température de 900 à 950° C, on broie et on compacte le mélange sous forme de pastilles que l'on fritte sous courant d'oxygène pendant plusieurs heures à une température d'environ 1050° C, et on refroidit lentement ces pastilles, toujours sous courant d'oxygène.

**5.** Un procédé selon la revendication 4, caractérisé en ce que les pastilles sont des disques de 4 mm d'épaisseur et 10 mm de diamètre, le refroidissement se faisant avec une vitesse de descente en température de 30° C par heure.

**6.** Les composants élémentaires tels que fils, feuilles, couches minces obtenues par mise en forme des produits selon l'une des revendications 1 à 3.

**7.** Les ensembles électriques ou électroniques incorporant les composants selon la revendication 6 et des moyens de refroidissement.

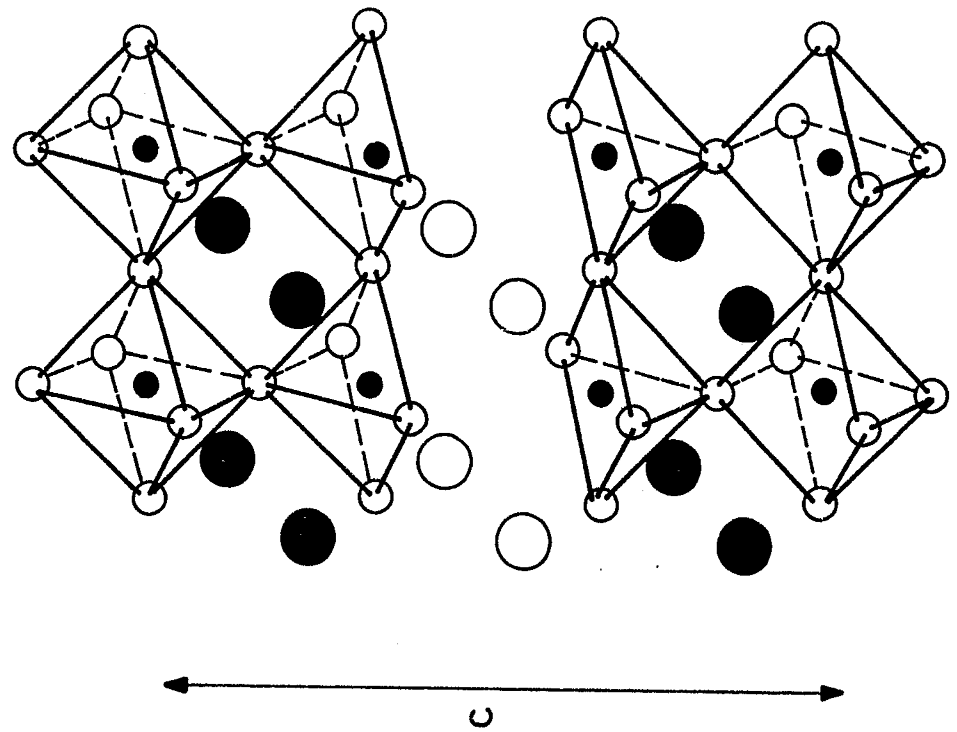


FIG_1b

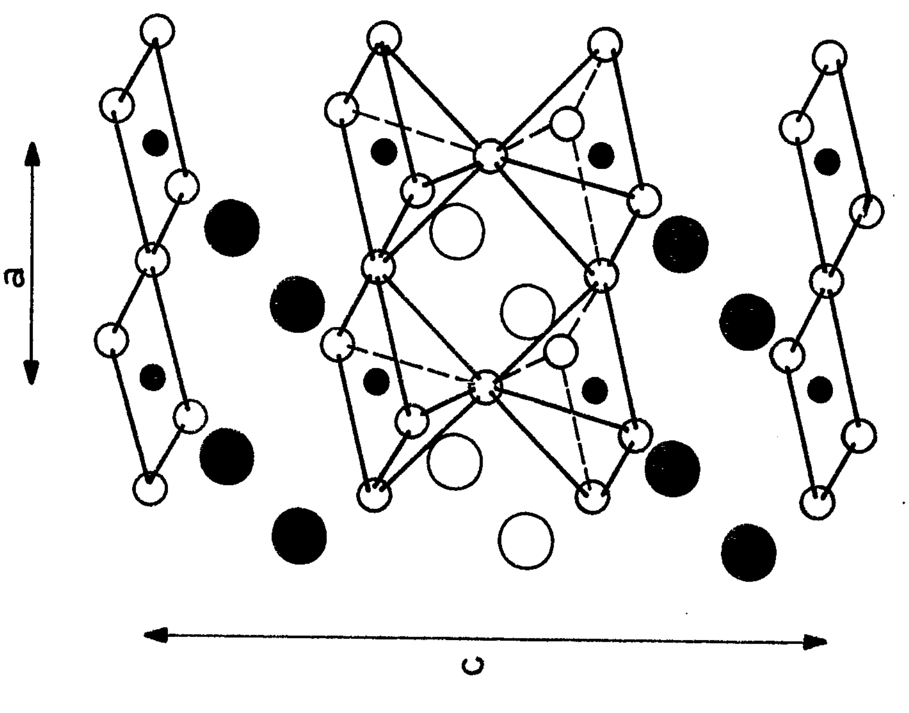


FIG_1a

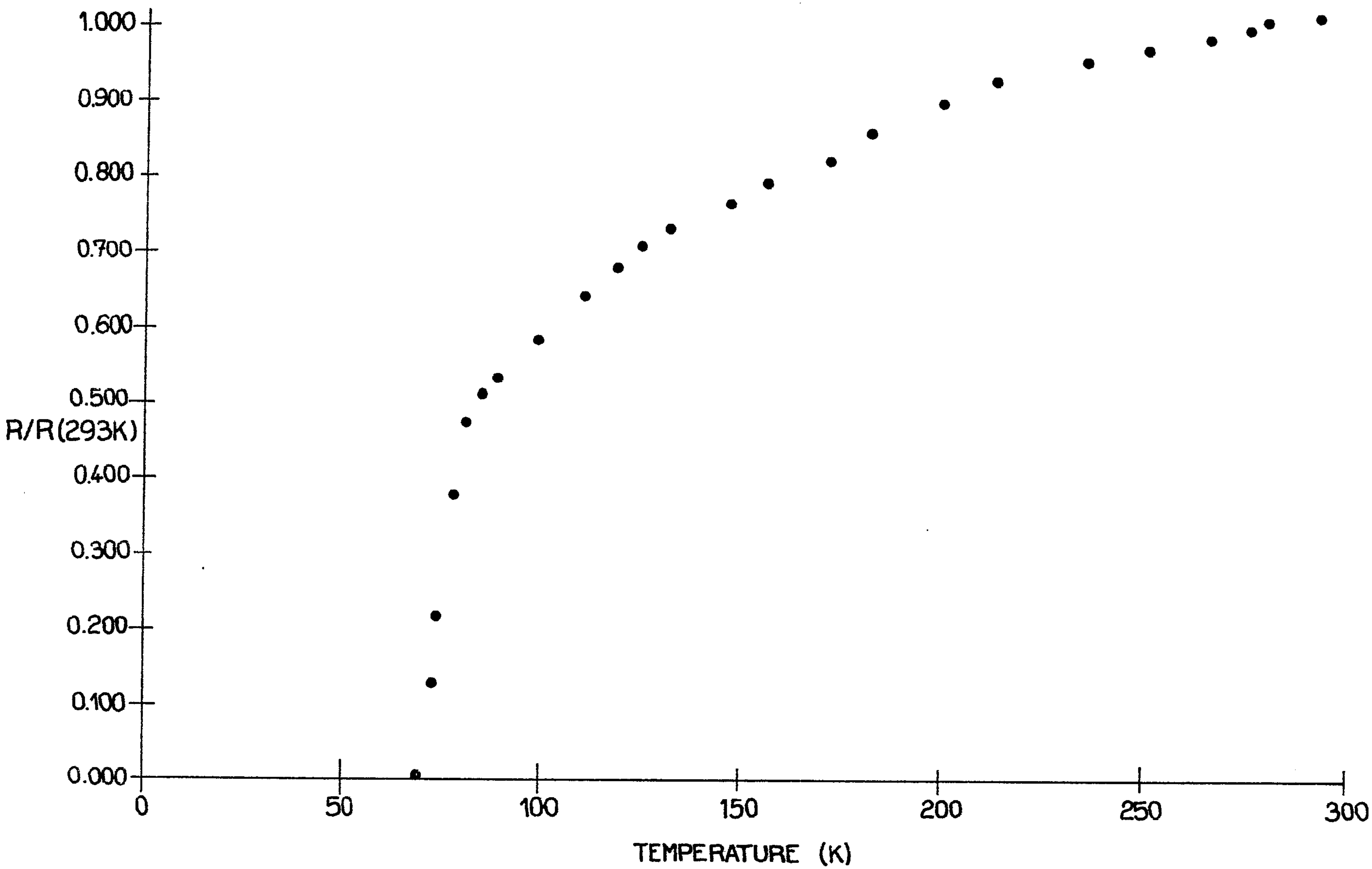
1.000
0.900
0.800
0.700
0.600
0.500
R/R(293K)
0.400
0.300
0.200
0.100
0.000
0
50
100
150
200
250
300
TEMPERATURE (K)

FIG-2

Office européen des brevets

# RAPPORT DE RECHERCHE EUROPEENNE

Numero de la demande

EP 88 40 0640

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | SCIENCE, vol. 235, 30 janvier 1987, pages 567-569, Lancaster, US; C.W. CHU et al.: "Superconductivity at 52.5 K in the lanthanum-barium-copper-oxide system" * En entier * | 1 | H 01 L 39/12<br>H 01 L 39/24 |
| D,A | REVUE DE CHIMIE MINERALE, tome 21, no. 4, 1984, pages 407-425, FR; C. MICHEL et al.: "Oxygen intercalation in mixed valence copper oxides related to the perovskites" | | |
| A | ZEITSCHRIFT FÜR PHYSIK B - CONDENSED MATTER, vol. 64, 1986, pages 189-193, Springer Verlag, Berlin, DE; J.G. BEDNORZ et al.: "Possible high Tc superconductivity in the Ba-La-Cu-O system" | | |
| P,X | PHYSICAL REVIEW LETTERS, vol. 58, no. 18, 4 mai 1987, pages 1891-1894, The American Physical Society, New York, US; P.H. HOR et al.: "Superconductivity above 90 K in the square-planar compound system ABa2Cu3O6+x with A=Y,La, Nd, Sm, Eu, Gd, Ho, Er, and Lu" * En entier * | 1,3 | DOMAINES TECHNIQUES RECHERCHES (Int. Cl.4)<br>H 01 L |

Le présent rapport a été établi pour toutes les revendications

| Lieu de la recherche | Date d'achèvement de la recherche | Examinateur |
|---|---|---|
| LA HAYE | 24-06-1988 | BAILLET B.J.R. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant